**Europäisches Patentamt**

(19) **European Patent Office**

**Office européen des brevets**

(11) Publication number : **0 380 109 B1**

(12) **EUROPEAN PATENT SPECIFICATION**

(45) Date of publication of patent specification :
26.04.95 Bulletin 95/17

(51) Int. Cl.⁶ : **G11C 7/06, G11C 11/409**

(21) Application number : **90101521.4**

(22) Date of filing : **25.01.90**

(54) **A semiconductor memory device.**

(30) Priority : **27.01.89 JP 18686/89**
**27.01.89 JP 18687/89**
**27.01.89 JP 18688/89**

(43) Date of publication of application :
**01.08.90 Bulletin 90/31**

(45) Publication of the grant of the patent :
**26.04.95 Bulletin 95/17**

(84) Designated Contracting States :
**DE FR GB NL**

(56) References cited :
**US-A- 4 346 458**
**US-A- 4 419 745**
**PATENT ABSTRACTS OF JAPAN, vol. 3, no. 1,**
**11th January 1979, page 167 E82; & JP-A-53**
**128 949 (HITACHI) 11-10-1978**

(56) References cited :
**IEEE JOURNAL OF SOLID STATE CIRCUITS,**
**vol. 22, no. 5, October 1987, pages 651-656,**
**New York, US; K. KIMURA et al.: "A 65-ns**
**4-Mbit CMOS DRAM with a twisted driveline**
**sense amplifier"**
**PATENT ABSTRACTS OF JAPAN, vol. 5, no. 9,**
**21st January 1981 (P-45)[681]; & JP-A-55 139**
**690 (NIPPON DENSHIN DENWA KOSHA) 31-**
**10-1980**

(73) Proprietor : **MATSUSHITA ELECTRONICS**
**CORPORATION**
**1006, Ohaza Kadoma**
**Kadoma-shi, Osaka 571 (JP)**

(72) Inventor : **Sumi, Tatsumi**
**1-5-19-404, Wakayamadai, Shimamoto-cho**
**Mishima-gun, Osaka (JP)**

(74) Representative : **Schwabe - Sandmair - Marx**
**Stuntzstrasse 16**
**D-81677 München (DE)**

# Description

This invention relates to a semiconductor memory device, and more particularly to a semiconductor memory device having an improved circuitry for supplying currents to sense amplifiers as defined in the preamble of claim 1.

A semiconductor memory device includes a plurality of memory cell blocks each comprising a plurality of memory cells which are connected to a pair of bit lines. Conventionally, a sense amplifier is disposed for each memory cell block to amplify a microvoltage read from memory cells of the corresponding memory cell block via the pair of bit lines. The sense amplifiers are arranged in a row at one end of the memory cell blocks to form a sense amplifier block.

With a higher degree cf integration of semiconductor memory devices, a memory cell block involves an increased number of memory cells therein, which leads to an increase of the number of memory blocks and an increase of the number of sense amplifiers provided in corresponding relation to the memory blocks. This results in increased parasitic resistance caused by a wiring (hereinafter, such resistance is referred to as merely "parasitic resistance"), and accordingly in a reduced rate of reading data from memory cells. However, a strong market demand exists for a highly integrated semiconductor memory device which can perform high-rate data reading.

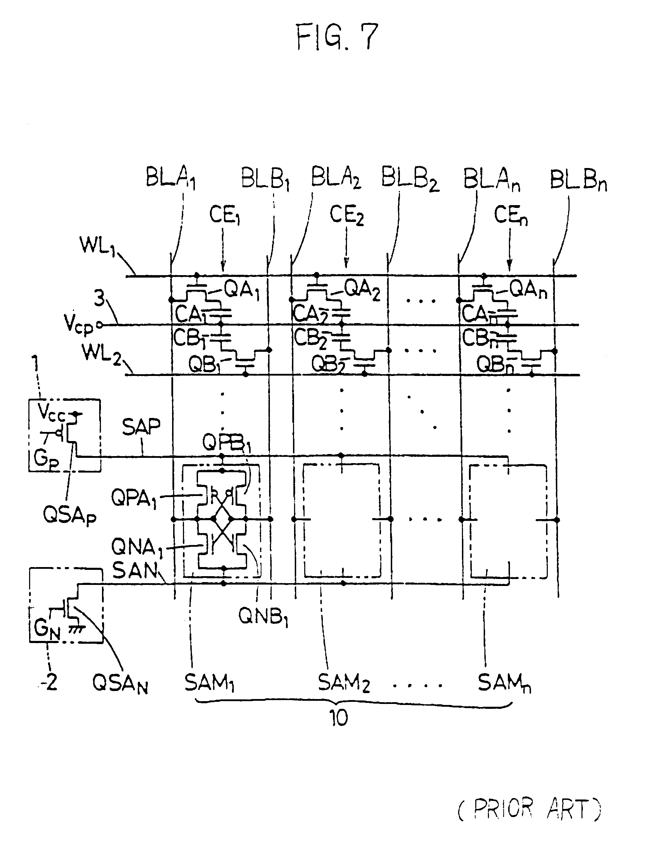

The structure of a conventional semiconductor memory device as it is known e.g. from IEEE JOURNAL OF SOLID STATE CIRCUITS, vol. 22, no. 5, October 1987, pages 651-656, New-York, US; K. KIMURA et al.: "A 65-ns 4-Mbit CMOS DRAM with a twisted driveline sense amplifier" (see preamble of claim 1) will be described more specifically with reference to Figure 7. The memory device of Figure 7 comprises sense amplifiers $SAM_1$, $SAM_2$, ..., $SAM_n$ for amplifying respectively signals from pairs of bit lines $BLA_1$ and $BLB_1$, $BLA_2$ and $BLB_2$, ..., $BLA_n$ and $BLB_n$. These sense amplifiers $SAM_1$ - $SAM_n$ constitute a sense amplifier block 10. Each of the pairs of bit lines $BLA_1$ and $BLB_1$, $BLA_2$ and $BLB_2$, ..., $BLA_n$ and $BLB_n$ is connected commonly to a group of memory cells, which constitute a memory cell block. In Figure 7, only memory cells $CE_1$ - $CE_n$ to which signals are commonly given from word lines $WL_1$ and $WL_2$ are shown for individual memory cell blocks, and other memory cells are not shown.

The memory cells $CE_1$ $CE_2$, ..., $CE_n$ respectively comprise memory cell transistors $QA_1$, $QA_2$, ..., $QA_n$ each having a gate connected to the word line $WL_1$, memory cell transistors $QB_1$, $QB_2$, ..., $QB_n$ each having a gate connected to the word line $WL_2$, memory cell capacitances $CA_1$, $CA_2$, ..., $CA_n$ connected to the memory cell transistors $QA_1$, $QA_2$, ..., $QA_n$ respectively and also to a line 3 to which a cell plate voltage $V_{cp}$ is applied, and memory cell capacitances $CB_1$, $CB_2$, ..., $CB_n$ connected to the memory cell transistors $QB_1$, $QB_2$, ..., $QB_n$ respectively and also to the line 3. When signals are supplied from the word lines $WL_1$ or $WL_2$, data retained in the memory cells $CE_1$ - $CE_n$ are sent to the pairs of bit lines $BLA_1$ and $BLB_1$ - $BLA_n$ and $BLB_n$.

The sense amplifier $SAM_1$ includes P-channel transistors $QPA_1$ and $QPB_1$, and N-channel transistors $QNA_1$ and $QNB_1$. To the source of each of the P-channel transistors $QPA_1$ and $QPB_1$, a current is supplied through a wiring SAP from a current source 1 which comprises a P-channel transistor $QSA_P$, and, to the source of each of the N-channel transistors $QNA_1$ and $QNB_1$, a current is supplied through another wiring SAN from another current source 2 which comprises an N-channel transistor $QSA_N$. The gates of the transistors $QPA_1$ and $QNA_1$ and the drains of the transistors $QPB_1$ and $QNB_1$ are commonly connected to the bit line $BLB_1$, and the gates of the transistors $QPB_1$ and $QNB_1$ and the drains of the transistors $QPA_1$ and $QNA_1$ are commonly connected to the bit line $BLA_1$. The other sense amplifiers $SAM_2$ - $SAM_n$ are constructed similarly.

In Figure 7, $V_{cc}$ designates a power source voltage, and $G_P$ and $G_N$ designate respective gates of the transistors $QSA_P$ and $QSA_N$.

When the potential of the word line $WL_1$ is raised to HIGH, data stored in the memory cell capacitances $CA_1$, $CA_2$, ..., $CA_n$ are supplied to the bit lines $BLA_1$, $BLA_2$, ..., $BLA_n$ via the memory cell transistors $QA_1$, $QA_2$, ..., $QA_n$. When, for example, the data supplied to the bit line $BLA_1$ is "H" (which is the data representing the H level), the voltage of the bit line $BLA_1$ is higher than that of the bit line $BLB_1$ by several hundreds of millivolts, so that the transistors $QPA_1$ and $QNB_1$ in the sense amplifier $SAM_1$ are turned on. Once an H level signal is given to the gate $G_N$ of transistor $QSA_N$ of the current source 2, the current source 2 begins to conduct the current withdrawal against the wiring SAN, whereupon the transistor $QNB_1$ which is in the conductive state begins to lower the voltage of the bit line $BLB_1$.

On the other hand, an L level signal is inputted to the gate $G_P$ of the transistor $QSA_P$ of the current source 1 with a slight lag behind the timing of the application of the H level signal to the gate $G_N$. Then, the current source 1 begins to supply current to the wiring SAP so that the transistor $QPA_1$ in the conducting state boosts the voltage in the bit line $BLA_1$. During this process, the transistors $QNA_1$ and $QPB_1$ do not operate.

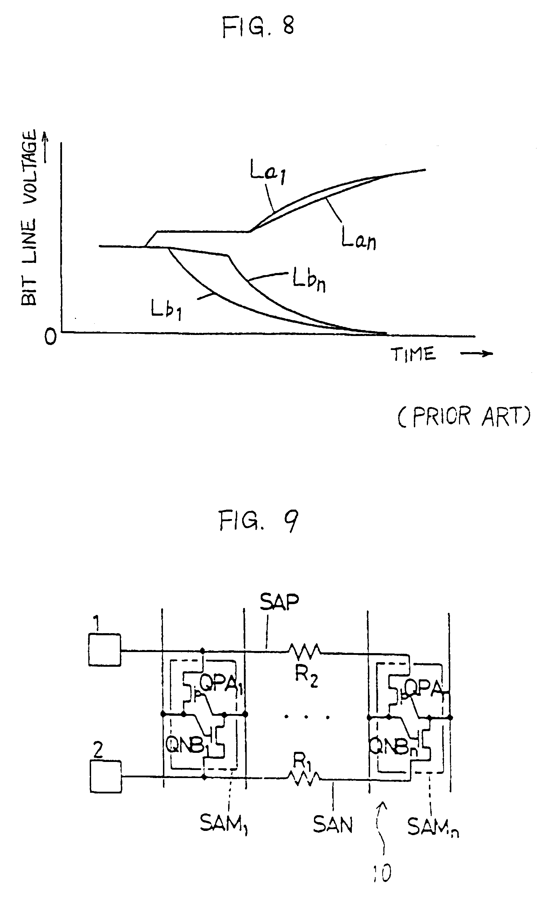

Such voltage changes in the bit lines $BLA_1$ and $BLB_1$ are shown respectively by vurves $La_1$ and $Lb_1$ in Figure 8. The difference between the voltages thus read on bit lines $BLA_1$ and $BLB_1$ which indicates the stored data is amplified by the sense amplifier.

Figure 9 shows a simplified equivalent circuit of the sense amplifier block 10 comprising the sense

amplifiers $SAM_1$ - $SAM_n$. In Figure 9, $R_1$ and $R_2$ represent parasitic resistances in the wirings SAN and SAP, respectively. To simplify the illustration, only transistors which are at the turn-on state in the above-described condition are shown in the sense amplifier block 10. When the current source 2 begins to withdraw current from the wiring SAN, a voltage drop occurs in the wiring SAN because of the presence of the parasitic resistance $R_1$. Accordingly, the gate-source voltages in the transistors $QNB_1$ and $QNB_n$ change in such a way that the voltage in transistor $QNB_n$ is smaller, thereby causing a delay in the sense operation of the sense amplifier $SAM_n$ which is most remote from the current source 2.

In Figure 8, curves $La_n$ and $Lb_n$ show voltage changes in the bit lines $BLA_n$ and $BLB_n$, respectively. From Figure 8, it can be understood that there is some lag in voltage drop in the bit line $BLB_n$ as compared in the bit line $BLB_1$.

In such a semiconductor memory device, the data reading rate depends on the sense operation speed of the sense amplifier $SAM_n$ which is most remote from the current source 2, and moreover the sense operation speed is determined by the length of the wiring extending from the current source 2 to the sense amplifier $SAM_n$ (that is, the magnitude of parasitic resistance therein). Therefore, in a highly integrated semiconductor memory device involving a long length of wiring SAN, the problem of increased read time is inevitable.

The semiconductor memory device of this invention, which overcomes the above-discussed and numerous other disadvantages and deficiencies of the prior art, comprises a sense amplifier block in which block a plurality of sense amplifiers are arranged in a row; and a current source disposed in the vicinity of one end of said sense amplifier block, said memory device further comprises: a first wiring connected commonly to said sense amplifiers, one end of said first wiring being connected to said current source; and a second wiring connecting said current source with the other end of said first wiring at one of said sense amplifiers which is most separated from said current source.

A preferred embodiment of the semiconductor memory device, according to the invention, comprises: a sense amplifier block in which block a plurality of sense amplifiers are arranged in a row; and a current source disposed in the vicinity of one end of said sense amplifier block, said memory device further comprises a strip including said first and said second wirings and made of a conductor material, said strip elongating along said row of said sense amplifiers, one end of said strip being connected to said current source, said strip being divided into first and second sections by a slit to form said first and said second wirings, which slit elongates along said row of said sense amplifiers, said first and second sections being connected with each other at both ends, said first section being connected to said current source and commonly to said sense amplifiers, said second section connecting said current source with one of said sense amplifiers which is most separated from said current source.

In a preferred embodiment, the memory device further comprises a resistance means which is connected between said current source and said one end of said first wiring.

Thus, the invention described herein makes possible the objectives:

(1) providing a semiconductor memory device which has a high reading rate;

(2) providing a semiconductor memory device in which sense amplifiers can operate at higher speed; and

(3) providing a semiconductor memory device in which the voltage drop caused by parasitic resistance can be effectively reduced even if a wiring for supplying current to sense amplifiers is long.

This invention may be better understood and its numerous objects and advantages will become apparent to those skilled in the art by reference to the accompanying drawings as follows:

Figure 1 is a circuit diagram showing a first embodiment of the invention.

Figure 2 is an equivalent circuit diagram of the vicinity of the sense amplifiers of the embodiment of Figure 1.

Figure 3 is a graph showing voltage drops in a wiring of the embodiment of Figure 1.

Figure 4 is a circuit diagram showing a second embodiment of the invention.

Figure 5 is a circuit diagram showing a third embodiment of the invention.

Figure 6 is an equivalent circuit diagram of the vicinity of the sense amplifiers of the embodiment of Figure 4.

Figure 7 is a circuit diagram showing a conventional memory device.

Figure 8 is a graph showing voltage drops in a wiring of the memory device of Figure 7.

Figure 9 is an equivalent circuit diagram of the vicinity of sense amplifiers of a memory device.

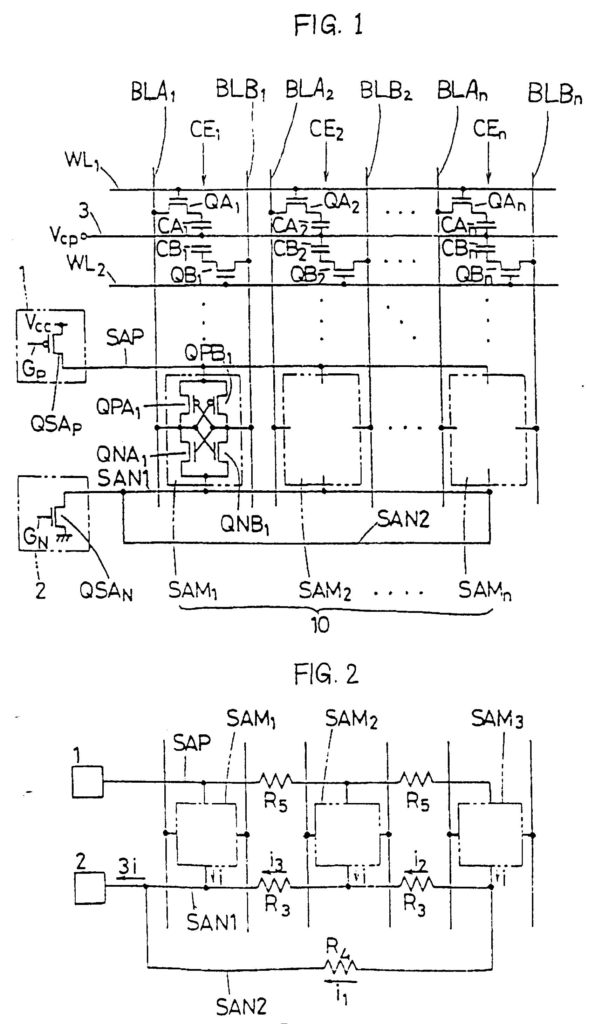

Figure 1 is an electric circuit diagram showing a basic arrangement of a semiconductor memory device according to the invention. In Figure 1, elements similar to those shown in Figure 7 are designated by the same reference numerals. In the semiconductor memory device of Figure 1, a first wiring SAN1 is connected commonly to a plurality of sense amplifiers $SAM_1$ - $SAM_n$ which constitute a sense amplifier block 10. One end of the first wiring SAN1 is connected to a current source 2. Further, a second wiring SAN2 is formed between the current source 2 and the sense amplifier $SAM_n$ which is disposed most remotely from the current source 2.

Figure 2 is an equivalent circuit diagram of the vicinity of the sense amplifier block 10 in which only three sense amplifiers $SAM_1$ $SAM_2$ and $SAM_3$ (i.e., in the case of n = 3). In the first wiring SAN1 there is present parasitic resistance $R_3$ between the sense amplifiers $SAM_1$ and $SAM_2$, and also between the sense amplifiers $SAM_2$ and $SAM_3$, while in the second wiring SAN2 there is present a parasitic resistance $R_4$. Reference numeral $R_5$ designates a parasitic resistance which is present in a wiring SAP between the sense amplifiers $SAM_1$ and $SAM_2$ and also between the sense amplifiers $SAM_2$ and $SAM_3$. As described above, the operation of the first current source 1 lags behind that of the second current source 2 which has an important role in the reading operation, and does not affect the reading rate. Hence, in the following description, currents flowing during the period when the first current source 1 is activated are not considered. For the same reason, the parasitic resistance $R_5$ has no bearing upon the reading rate. Currents flowing respectively through the sense amplifiers $SAM_1$ $SAM_2$ and $SAM_3$ are the same in level. In the following description, these currents are represented by i.

Where the current flowing through the second wiring SAN2 is represented by $i_1$, the current flowing between the sense amplifiers $SAM_2$ and $SAM_3$ in the first wiring SAN1 is represented by $i_2$, and the current flowing between the sense amplifiers $SAM_2$ and $SAM_3$ is represented by $i_3$, the following relations hold:

$$i_1 = i - i_2 \quad (1)$$

$$i_3 = i + i_2 \quad (2)$$

$$i_1 \cdot R_4 = i_3 \cdot R_3 + i_2 \cdot R_3 \quad (3)$$

When the first and second wirings SAN1 and SAN2 are constructed so as to have parasitic resistance equal to each other,

$$R_4 = 2R_3 \quad (4)$$

Then, the following relation holds:

$$i_2 = i/4 \quad (5)$$

Therefore, the voltage drop $\Delta V_{12}$ between sense amplifiers $SAM_1$ and $SAM_2$, and the voltage drop $\Delta V_{23}$ between sense amplifiers $SAM_2$ and $SAM_3$ can be expressed by the following relation:

$$\Delta V_{12} = 5i \cdot R_3/4 \quad (6)$$

$$\Delta V_{23} = i \cdot R_3/4 \quad (7)$$

When assuming that the second wiring $SAN_2$ is not formed, that is, when the memory device has the prior art structure, the following relation holds:

$$\Delta V_{12} = 2i \cdot R_3 \quad (8)$$

$$\Delta V_{23} = i \cdot R_3 \quad (9)$$

According to this embodiment, therefore, it can be understood that the voltage drops $\Delta V_{12}$ and $\Delta V_{23}$ can be effectively reduced as compared with the prior art level.

Even if the parasitic resistance of the first wiring SAN1 is reduced by half in the prior art structure, the voltage drops $\Delta V_{12}$ and $\Delta V_{23}$ becomes as follows:

$$\Delta V_{12} = i \cdot R_3 \quad (10)$$

$$\Delta V_{23} = i \cdot R_3/2 \quad (11)$$

From the above, it is apparent that the voltage drop $\Delta V_{23}$ in this embodiment can be effectively reduced as compared with the above-mentioned ideal case.

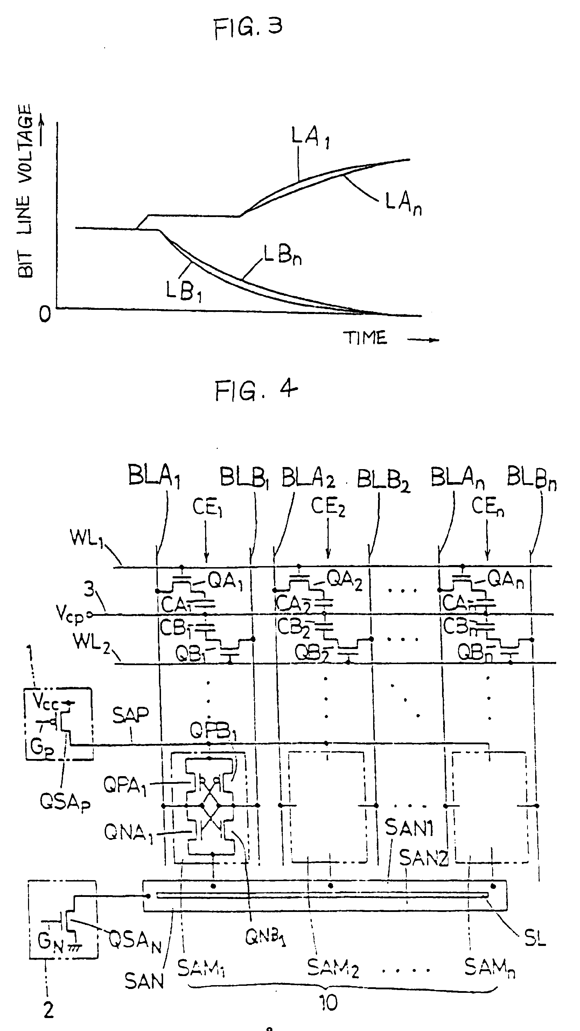

Figure 3 is a graph showing voltage changes in the bit lines $BLA_1$, $BLB_1$, $BLA_n$ and $BLB_n$ in the embodiment of Figure 1. In Figure 3, voltage changes in the bit lines $BLA_1$, $BLB_1$, $BLA_n$ and $BLB_n$ are shown by vurves $LA_1$, $LB_1$, $LA_n$ and $LB_n$, respectively. By comparing Figures 3 and 8, it can be seen that the delay in voltage drop in the bit line $BLB_n$ is remarkably reduced. In this way, the sense operation rate of the sensor amplifier $SAM_n$ which is most remote from current source 2 can be significantly improved.

Figure 4 shows another memory device according to the invention. This embodiment has a structure which is similar to that of the memory device of Figure 1, except that the first and second wirings SAN1 and SAN2 are formed integrally. More specifically, the first and second wirings SAN1 and SAN2 are constituted respectively by first and second elongate sections of a metal strip SAN which extends in the direction of the row of the sense amplifiers $SAM_1$ - $SAM_n$, and are separated by a slit SL which is formed in the center portion of the metal strip SAN. Both ends of the first and second wirings SAN1 and SAN2 are electrically connected to each other. The equivalent circuit of this embodiment is as shown in Figure 2, and the operation of this embodiment is substantially the same as that of the embodiment of Figure 1.

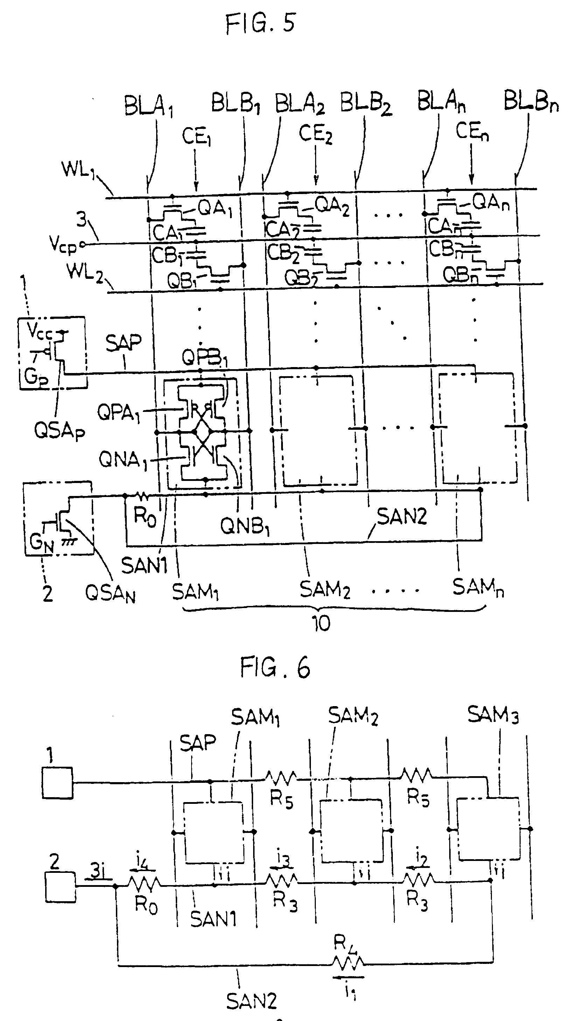

Figure 5 shows a further memory device according to the invention. In this embodiment, a resistor $R_0$ is interposed between the current source 2 and one end of the first wiring SAN1. Figure 6 is an equivalent circuit diagram of this embodiment. As seen from above expressions (4) and (5), the voltage drops $\Delta V_{12}$ and $\Delta V_{23}$ in the memory device of Figure 1 are not equal. Thus, sense operation rates of the individual sense amplifiers including the one nearest to the current source and one remotest may be slightly different from each other. The memory device of Figure 5 can eliminate this difficulty. When the current flowing through the resistor $R_0$ is represented by $i_4$, the following relations hold:

$$i_1 = i - i_2 \quad (12)$$

$$i_3 = i + i_2 \quad (13)$$

$$i_4 = 2 \cdot i + i_2 \quad (14)$$

$$i_1 \cdot R_4 = i_4 \cdot R_0 + i_3 \cdot R_3 + i_2 \cdot R_3 \quad (15)$$

When the first and second wirings SAN1 and SAN2 are constructed so as to have parasitic resistance equal to each other,

$$R_4 = 2 \cdot R_3 \quad (16)$$

The value of the resistance $R_0$ can be expressed us-

ing the parasitic resistance $R_3$ of the first wiring SAN1 as follows:

$$R_0 = k \cdot R_3 \quad (17)$$

where k is a constant. Then, the following relations can be obtained from expressions (12) - (14):

$$i_2 = i \cdot (1 - 2k) / (k + 4) \quad (18)$$

$$i_3 = i \cdot (5 - k) / (k + 4) \quad (19)$$

When assuming

$$k = 2 \quad (20)$$

that is assuming the value of the resistor $R_0$ is twice the value of the parasitic resistance $R_3$,

$$i_2 = i_3 = i/2 \quad (21)$$

The voltage drops $\Delta V_{12}$ and $\Delta V_{23}$ between sense amplifiers SAM$_1$ and SAM$_2$ becomes as follows:

$$\Delta V_{12} = \Delta V_{23} = i \cdot R_3/2 \quad (22)$$

Consequently, the voltage drops $\Delta V_{12}$ and $\Delta V_{23}$ in the embodiment of Figure 5 can be significantly reduced as compared with the prior art device, and moreover the voltage drops $\Delta V_{12}$ and $\Delta V_{23}$ can be equalized. It can be understood from this fact that the resistor $R_0$ has a function which eliminates the effect of the parasitic resistance of the second wiring SAN2, and thereby uniformly reducing possible voltage drops in the wirings connected to the sense amplifiers. The voltage changes in the bit lines BLA$_1$, BLB$_1$, BLA$_n$ and BLB$_n$ in the embodiment of Figure 5 is substantially similar to those shown in Figure 3.

In the above, embodiments having three sense amplifiers are illustrated. It is apparent that the number of sense amplifiers in a memory device according to the invention is not restricted to three.

According to the present invention, as above described, a sense amplifier disposed most remote from a current source (the current source 2 in the illustrated embodiments) can be allowed to perform the sense operation with almost the same speed of response as that of another sense amplifier nearest to the current source, which means considerable improvement in the data read rate in the performance of the semiconductor memory device. In a highly integrated semiconductor memory device which involves increased wiring length and accordingly increased parasitic resistance, the arrangement of the invention is particularly advantageous in that voltage drop due to the parasitic resistance of the wiring can be reduced so that the sense amplifiers are allowed to operate at higher speed in order to perform higher-speed data reading.

**Claims**

1. A semiconductor memory device comprising: a sense amplifier block in which block a plurality of sense amplifiers (SAM$_1$-SAM$_n$) are arranged in a row and a current source (2) disposed in the vicinity of one end of said sense amplifier block,

said memory device further comprises:

a first wiring (SAN1) connected commonly to said sense amplifiers (SAM$_1$-SAM$_n$), one end of said first wiring being connected to said current source (2), characterized by

a second wiring (SAN2) connecting said current source (2) with the other end of said first wiring at one of said sense amplifiers (SAM$_n$) which is most separated from said current source (2).

2. A semiconductor memory device according to claim 1, said memory device further comprising a strip (SAN) including said first and said second wirings (SAN1, SAN2) and made of a conductor material, said strip (SAN) elongating along said row of said sense amplifiers (SAM$_1$-SAM$_n$), one end of said strip being connected to said current source, said strip being divided into first and second sections as said first and said second wirings by a slit (SL) which elongates along said row of said sense amplifiers, said first and second sections (SAN1, SAN2) being connected with each other at both ends.

3. A semiconductor memory device according to one of claims 1 or 2, wherein said memory device further comprises a resistance means ($R_0$) which is connected between said current source (2) and said one end of said first wiring (SAN1) or said first section of said strip.

**Patentansprüche**

1. Halbleiter-Speichervorrichtung, die folgendes aufweist: einen Abtastverstärkerblock, in dem eine Anzahl von Abtastverstärkern (SAM$_1$-SAM$_n$) in einer Reihe angeordnet sind, und eine Stromquelle (2), die in der Nähe von einem Ende des Abtastverstärkerblocks angeordnet ist,

wobei die Speichervorrichtung weiter folgendes aufweist:

eine erste Verdrahtung bzw. Leiterbahnbelegung (SAN1), die gemeinhin an die Leseverstärker (SAM$_1$-SAM$_n$) angeschlossen ist, wobei ein Ende der ersten Verdrahtung bzw. Leiterbahnbelegung mit der Stromquelle (2) verbunden bzw. an diese angeschlossen ist, **gekennzeichnet** durch

eine zweite Verdrahtung bzw. Leiterbahnbelegung (SAN2), die die Stromquelle (2) mit dem anderen Ende der ersten Verdrahtung bei einem der Abtastverstärker (SAM$_n$) verbindet, der am weitesten von der Stromquelle (2) beabstandet ist.

**2.** Halbleiter-Speichervorrichtung gemäß Anspruch 1, wobei die Speichervorrichtung ferner einen Streifen (SAN) aufweist, der die erste und die zweite Verdrahtung (SAN1, SAN2) umfaßt und aus einem leitenden Material hergestellt ist, wobei sich der Streifen (SAN) entlang der Reihe der Abtastverstärker (SAM₁-SAMₙ) erstreckt, wobei ein Ende des Streifens mit der Stromquelle verbunden bzw. daran angeschlossen ist, wobei der Streifen ebenso wie die erste und die zweite Verdrahtung durch einen Schlitz (SL) in erste und zweite Abschnitte unterteilt ist, der sich entlang der Reihe der Abtastverstärker erstreckt, wobei die ersten und zweiten Abschnitte (SAN1, SAN2) miteinander an beiden Enden verbunden sind.

**3.** Halbleiter-Speichervorrichtung gemäß einem der Ansprüche 1 oder 2, bei der die Speichervorrichtung weiter eine Widerstandseinrichtung (R₀) aufweist, die zwischen der Stromquelle (2) und dem einen Ende der ersten Verdrahtung (SAN1) oder dem ersten Abschnitt des Streifens angeschlossen ist.

**Revendications**

**1.** Dispositif mémoire à semi-conducteurs comprenant : un bloc d'amplificateurs de détection, bloc dans lequel une multitude d'amplificateurs de détection (SAM₁ à SAMₙ) sont agencés en une rangée et dans lequel une source de courant (2) est disposée au voisinage d'une première extrémité dudit bloc d'amplificateurs de détection,

ledit dispositif mémoire comprenant en outre :

un premier câblage (SAN1) relié de manière commune auxdits amplificateurs de détection (SAM₁ à SAMₙ), une première extrémité dudit premier câblage étant reliée à ladite source de courant (2), caractérisé par

un second câblage (SAN2) reliant ladite source de courant (2) à l'autre extrémité dudit premier câblage à l'un desdits amplificateurs de détection (SAMₙ) qui est le plus séparé de ladite source de courant (2).

**2.** Dispositif mémoire à semi-conducteurs selon la revendication 1, ledit dispositif mémoire comprenant en outre une bande (SAN) incluant ledit premier et ledit second câblages (SAN1, SAN2) et qui est constituée d'un matériau conducteur, ladite bande (SAN) se prolongeant le long de ladite rangée desdits amplificateurs de détection (SAM₁ à SAMₙ), une première extrémité de ladite bande étant reliée à ladite source de courant, ladite bande étant divisée en des première et seconde sections de même que ledit premier et ledit second câblages par une fente (SL) qui se prolonge le long de ladite rangée desdits amplificateurs de détection, lesdites première et seconde sections (SAN1, SAN2) étant reliées entre elles aux deux extrémités.

**3.** Dispositif mémoire à semi-conducteurs selon l'une des revendications 1 ou 2, dans lequel ledit dispositif mémoire comprend en outre un moyen de résistance (R₀) qui est relié entre ladite source de courant (2) et ladite première extrémité dudit premier câblage (SAN1) ou ladite première section de ladite bande.

## FIG. 1

## FIG. 2

## FIG. 3

## FIG. 4

8

EP 0 380 109 B1

## FIG. 5

## FIG. 6

9

# FIG. 7

(PRIOR ART)

FIG. 8

(PRIOR ART)

FIG. 9